# EUROPEAN PATENT SPECIFICATION

(11) **EP 2 447 674 B1**
(45) Date of publication and mention of the grant of the patent: **26.09.2018**
(21) Application number: 10792043.1
(22) Date of filing: 21.06.2010
(51) Int. Cl.: G01R 33/09, G01D 5/245, B82Y 25/00

(54) **MAGNETIC DETECTION DEVICE**
MAGNETDETEKTIONSVORRICHTUNG
DISPOSITIF DE DÉTECTION MAGNÉTIQUE

(30) Priority: 24.06.2009 JP 2009150056
(43) Date of publication of application: 02.05.2012
(73) Proprietor: Alps Electric Co., Ltd., Tokyo 145-8501 (JP)
(72) Inventor: KAWAHATA, Ken, Tokyo 145-8501 (JP)
(74) Representative: Schmitt-Nilson Schraud Waibel Wohlfrom Patentanwälte Partnerschaft mbB
(86) International application number: PCT/JP2010/060432
(87) International publication number: WO 2010/150725

(56) References cited:
- WO-A1-2009/051069
- JP-A- H0 436 613
- JP-A- 61 173 113
- JP-A- S61 173 113
- JP-U- H 062 116
- US-A1- 2008 048 809

## Description

### TECHNICAL FIELD

The present invention relates to a magnetic detection device that is used in, for example, a high-resolution magnetic encoder.

### BACKGROUND ART

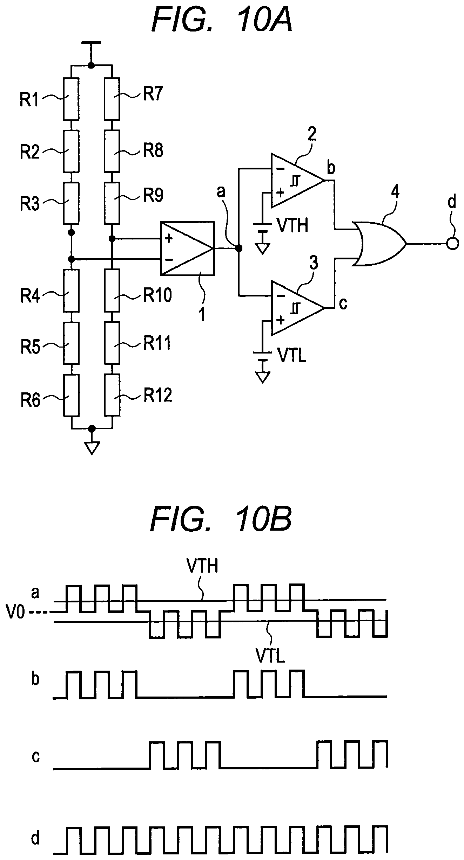

Fig. 10 is a signal processing circuit diagram and an output waveform diagram of a magnetic detection device (magnetic sensor) which is used in a high-resolution magnetic encoder according to the related art.

As shown in Fig. 10(a), a plurality of magnetic detection elements R1 to R12 form a bridge circuit. Among them, a plurality of magnetic detection elements R1 to R6 are connected in series to each other and an output voltage from an intermediate point that divides the plurality of magnetic detection elements R1 to R6 into two groups with the same number of magnetic detection elements is input to a differential amplifier 1. In addition, a plurality of magnetic detection elements R7 to R12 are connected in series to each other and an output voltage from an intermediate point that divides the plurality of magnetic detection elements R7 to R12 into two groups with the same number of magnetic detection elements is input to the differential amplifier 1.

A waveform diagram a shown in Fig. 10(b) shows an output waveform from the differential amplifier 1. As shown in Fig. 10(a), the output side of the differential amplifier 1 is branched into two lines, a Schmitt trigger comparator 2 having a threshold voltage VTH higher than a reference voltage V0 is connected one of the two branched lines, and a Schmitt trigger comparator 3 having a threshold voltage VTL lower than the reference voltage V0 is connected to the other line. The comparator 2 outputs a pulse signal with respect to an output voltage higher than the threshold voltage VTH (waveform diagram b in Fig. 10(b)). The comparator 3 outputs a pulse signal with respect to an output voltage lower than the threshold voltage VTL (waveform diagram c in Fig. 10(b)).

As shown in Fig. 10(a), an OR circuit 4 is connected to the output sides of the comparators 2 and 3. The OR circuit 4 synthesizes the pulse signal generated by the comparator 2 and the pulse signal generated by the comparator 3 to obtain a pulse signal shown in a waveform diagram d of Fig. 10(b).

In the bridge circuit having the circuit structure shown in Fig. 10(a), in order to obtain high detection accuracy, the differential amplifier 1 differentially amplifies an output voltage from the bridge circuit to form one output waveform and the Schmitt trigger comparators 2 and 3 are used to generate a pulse waveform. As a result, there is a problem in that the circuit structure becomes complicated and the size of the circuit structure increases.

Patent Document 1 discloses a circuit structure in which a plurality of magnetic detection elements are connected in series to each other between an input terminal and an intermediate point (output point) and between the intermediate point and a ground terminal. In addition, in Patent Document 1, "this voltage change is converted into a square wave signal by an amplifier or a comparator (not shown), ..." is described in paragraph [0030].

Patent Document 2 discloses a magnetic rotary encoder having an electric circuit including a bridge circuit including a plurality of magnetic detection elements, three differential amplifiers, and three comparators.

In the structures disclosed in Patent Documents, similarly to the related art, it is difficult to solve the problem of a complicated and large circuit structure.

### CITATION LIST

### PATENT DOCUMENT

Patent Document 1: Japanese Unexamined Patent Application Publication No. 2001-174286
Patent Document 2: Japanese Unexamined Patent Application Publication No. 4-36613

JP S61 173113 A discloses a magnetic rotation sensor whereby improving signal output and reducing electric power comsumption. The magnetic rotation sensor has the sensing parts MR5...MR10 of the thin film magnetoresistance element 15 formed on the insulating substrate 14. MR5, MR6 and MR7 among these sensing parts are arrayed in parallel at the interval of the wavelength of 1/3 the recording wavelength lambda of a signal magnetic field and are connected in series. MR8, MR9 and MR10 are also arrayed in parallel at the spacing of 1/3 the wavelength. The set of MR5, MR6 and MR7 and the set of MR8, MR9 and MR10 are arrayed at the spacing of 1/2 the wavelength in such a manner that the corresponding sensing parts parallel with each other. Two sets thereof are connected in parallel. The magnetic rotation sensor is thus prevented from being superposed with 1/2 the source voltage with the signal output as in the conventional practice and the signal output is improved 4/3 times. The electric power consumption is reduced to 2/3.

The present invention relates to a magnetic detection device according to the appended claims.

### DISCLOSURE OF THE INVENTION

### PROBLEMS TO BE SOLVED BY THE INVENTION

The invention has been made in order to solve the above-mentioned problems and, in particular, an object of the invention is to provide a magnetic detection device capable of achieving a small circuit structure and high detection accuracy, as compared to the related art.

### MEANS FOR SOLVING THE PROBLEMS

According to an aspect of the invention, there is provided a magnetic detection device including a bridge circuit including a plurality of magnetic detection elements whose magnetic characteristics are changed by an external magnetic field. Two output portions are provided at an intermediate point of each series circuit of the bridge circuit. Resistive units are connected between a first output portion which is provided on an input terminal side of one series circuit and a second output portion which is provided on a ground terminal side of the one series circuit and between a third output portion which is provided on an input terminal side of the other series circuit and a fourth output portion which is provided on a ground terminal side of the other series circuit. The first output portion and the fourth output portion are connected to a first comparator, and the second output portion and the third output portion are connected to a second comparator.

Specifically, the magnetic detection elements forming the first detecting unit and the second detecting unit may be connected in series to each other in a first series circuit of the bridge circuit. The first detecting unit may be connected to an input terminal, and the second detecting unit may be connected to a ground terminal. A first resistive unit may be connected between the first detecting unit and the second detecting unit. The first output portion may be provided between the first detecting unit and the first resistive unit and the second output portion may be provided between the second detecting unit and the first resistive unit. A fourth detecting unit having a resistance value which is changed together with the resistance value of the first detecting unit and a third detecting unit having a resistance value which is changed together with the resistance value of the second detecting unit may be provided in a second series circuit of the bridge circuit. The magnetic detection elements forming the third detecting unit and the fourth detecting unit are connected in series to each other. The third detecting unit may be connected to the input terminal and the fourth detecting unit may be connected to the ground terminal. A second resistive unit may be connected between the third detecting unit and the fourth detecting unit. The third output portion may be provided between the third detecting unit and the second resistive unit, and the fourth output portion may be provided between the fourth detecting unit and the second resistive unit.

In the invention, the first resistive unit and the second resistive unit are connected to the intermediate positions of the series circuits of the bridge circuit. Therefore, it is possible to shift the reference voltages of the output voltages from the first output portion and the third output portion which are provided closer to the input terminal than each resistive unit to be higher than the reference voltage in the structure according to the related art in which the resistive units are not provided. In addition, it is possible to shift the reference voltages of the output voltages from the second output portion and the fourth output portion which are provided closer to the ground terminal than each resistive unit to be lower than the reference voltage in the structure according to the related art in which the resistive units are not provided. Therefore, a potential difference occurs between the reference voltages of the output voltages from the first output portion and the fourth output portion which are connected to the same comparator in advance. Similarly, a potential difference occurs between the reference voltages of the output voltages from the second output portion and the third output portion connected to the same comparator in advance. As a result, even when, for example, a differential amplifier is not used in order to obtain a single-ended signal in the first stage of a signal processing circuit, the connection between each output portion and each comparator enables each comparator to generate a pulse signal with high accuracy. Therefore, it is possible to achieve a small circuit structure and high detection accuracy, as compared to the related art.

In the invention, each of the first resistive unit and the second resistive unit may include a plurality of magnetic detection elements connected in series to each other. The magnetic detection elements forming the first resistive unit may be arranged such that the resistance values thereof are changed corresponding to the resistance values of the magnetic detection elements forming the first detecting unit and the second detecting unit. The magnetic detection elements forming the second resistive unit may be arranged such that the resistance values thereof are changed corresponding to the resistance values of the magnetic detection elements forming the third detecting unit and the fourth detecting unit.

As such, when each of the first resistive unit and the second resistive unit includes the magnetic detection elements and the magnetic detection elements forming the first resistive unit and the second resistive unit are connected in series to each other, it is possible to reduce a variation in the resistance value or temperature characteristics of each magnetic detection element. In addition, it is possible to obtain a substantially constant threshold voltage. That is, it is possible to effectively obtain a constant threshold voltage, as compared to the structure in which the first resistive unit and the second resistive unit are fixed resistors . The threshold voltage is calculated by a voltage difference between the first output portion and the second output portion or a potential difference between the third output portion and the fourth output portion. As such, when the threshold voltage determined in this way is substantially constant, each comparator can generate a pulse signal with high accuracy and it is possible to improve operation stability.

Alternatively, in the invention, each of the first resistive unit and the second resistive unit may include a plurality of magnetic detection elements connected in parallel to each other. The magnetic detection elements forming the first resistive unit are arranged such that the resistance values thereof are changed corresponding to the resistance values of the magnetic detection elements forming the first detecting unit and the second detecting unit. The magnetic detection elements forming the second resistive unit are arranged such that the resistance values thereof are changed corresponding to the resistance values of the magnetic detection elements forming the third detecting unit and the fourth detecting unit.

As such, when each of the first resistive unit and the second resistive unit includes the magnetic detection elements and the magnetic detection elements forming the first resistive unit and the second resistive unit are connected in parallel to each other, it is possible to reduce a variation in the resistance value or temperature characteristics of each magnetic detection element. In addition, it is possible to make the threshold voltage determined in this way substantially constant. In this way, each comparator can generate a pulse signal with high accuracy and it is possible to improve operation stability. In addition, when a plurality of magnetic detection elements forming the resistive unit are connected in parallel to each other rather than in series to each other, it is possible to increase the set value of the resistance value required for each magnetic detection element, as compared to the structure in which a plurality of magnetic detection elements forming the resistive unit are connected in series to each other. Therefore, it is possible to simplify the structure of the magnetic detection element.

In the invention, in the above-mentioned structure, the magnetic detection elements forming the first detecting unit and the second detecting unit may be arranged so as to face a magnetized surface, which generates the external magnetic field in which the N-poles and the S-poles are alternately arranged in a relative movement direction, with a gap therebetween in the relative movement direction. The magnetic detection elements forming the third detecting unit may be arranged so as to face the magnetic detection elements forming the second detecting unit with a gap therebetween in a direction orthogonal to the relative movement direction. The magnetic detection elements forming the fourth detecting unit may be arranged so as to face the magnetic detection elements forming the first detecting unit with a gap therebetween in the direction orthogonal to the relative movement direction. The magnetic detection elements forming the first resistive unit may be arranged so as to face the magnetic detection elements forming the first detecting unit and the second detecting unit with a gap therebetween in the direction orthogonal to the relative movement direction. The magnetic detection elements forming the second resistive unit may be arranged so as to face the magnetic detection elements forming the third detecting unit and the fourth detecting unit with a gap therebetween in the direction orthogonal to the relative movement direction. In this way, it is possible to effectively form a magnetic detection device with high detection accuracy and high operation stability.

In the invention, the first detecting unit, the second detecting unit, the third detecting unit, and the fourth detecting unit may include the same number of magnetic detection elements. The magnetic detection elements forming the first detecting unit and the magnetic detection elements forming the second detecting unit may be alternately arranged in the relative movement direction so as to be within a magnetic pole width. The magnetic detection elements forming the third detecting unit and the magnetic detection elements forming the fourth detecting unit may be alternately arranged in the relative movement direction so as to be within the magnetic pole width. In this way, it is possible to form a magnetic detection device which is applicable to, for example, a magnetic encoder with high resolution.

In the invention, the first resistive unit and the second resistive unit may be fixed resistors. As such, when the resistive unit is a fixed resistor, it is possible to easily perform wiring.

### ADVANTAGEOUS EFFECTS OF THE INVENTION

According to the magnetic detection device of the invention, it is possible to achieve a small circuit structure and high detection accuracy, as compared to the related art.

### BRIEF DESCRIPTION OF THE DRAWINGS

Fig. 1 is a plan view illustrating a magnetic encoder according to an embodiment.
Fig. 2 is a cross-sectional view illustrating the magnetic encoder shown in Fig. 1.
Fig. 3 (a) is a diagram illustrating the circuit structure of a magnetic detection device (magnetic sensor) according to a first embodiment and Fig. 3(b) is a diagram (schematic diagram) illustrating an output waveform at each position of an electric circuit shown in Fig. 3(a).
Fig. 4 is a diagram (simulation diagram) illustrating output waveforms from a1, a4, a4-a1, and a1-a2 in the first embodiment.
Fig. 5 is a diagram illustrating the arrangement structure of the magnetic detection device according to the first embodiment and is a schematic diagram illustrating the relationship between the magnetic detection device and a magnet.
Fig. 6(a) is a diagram illustrating the circuit structure of a magnetic detection device (magnetic sensor) according to a second embodiment and Fig. 6(b) is a diagram (simulation diagram) illustrating output waveforms from a1, a4, a4-a1, and a1-a2 in the second embodiment.
Fig. 7 is a diagram illustrating the arrangement structure of the magnetic detection device according to the second embodiment.
Fig. 8 (a) is a diagram illustrating the circuit structure of a magnetic detection device (magnetic sensor) according to a third embodiment and Fig. 8(b) is a diagram (simulation diagram) illustrating output waveforms from a1, a4, a4-a1, and a1-a2 in the third embodiment.
Fig. 9 is a diagram illustrating the arrangement structure of the magnetic detection device according to the third embodiment.
Fig. 10 is a signal processing circuit diagram and an output waveform diagram of a magnetic detection device according to the related art.

### BEST MODE FOR CARRYING OUT THE INVENTION

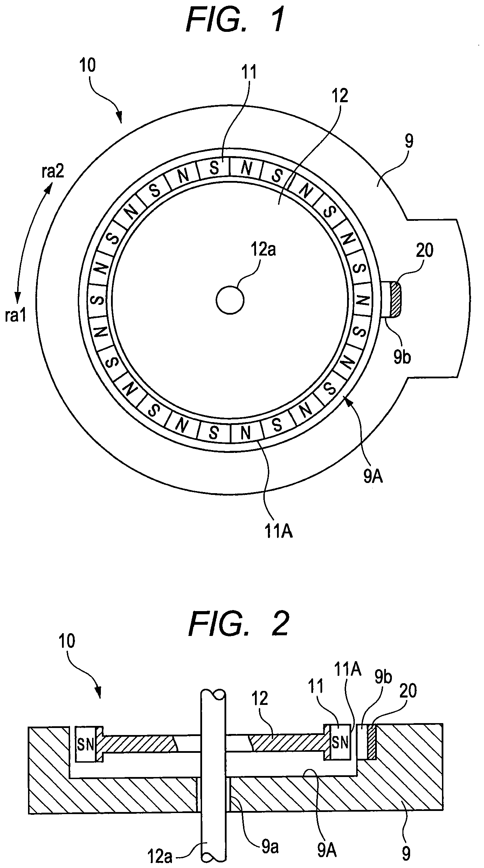

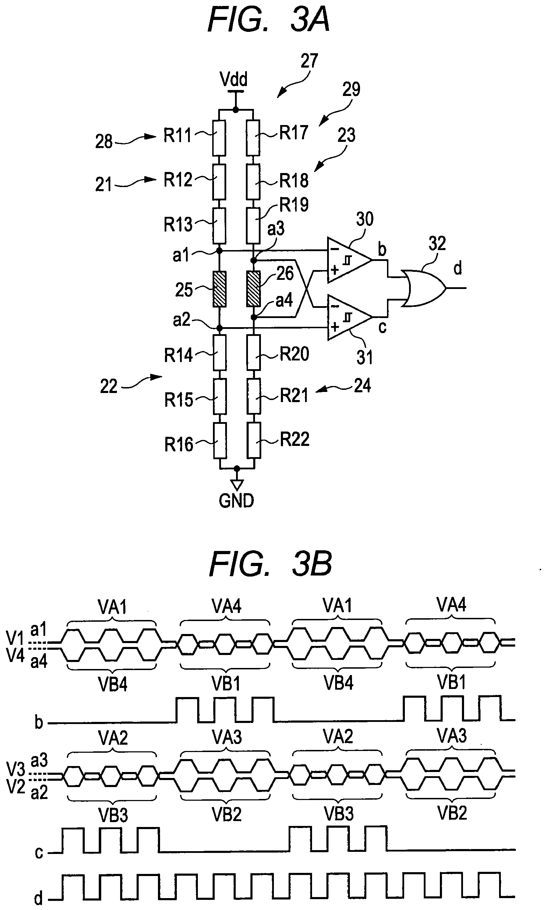

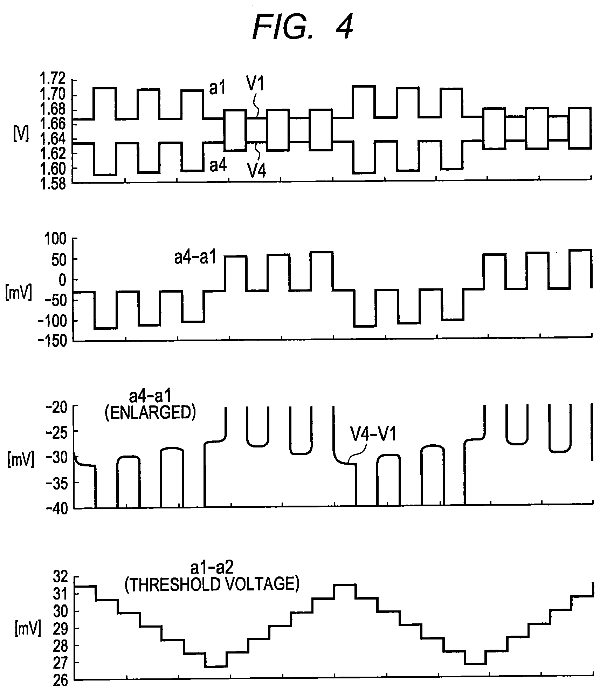

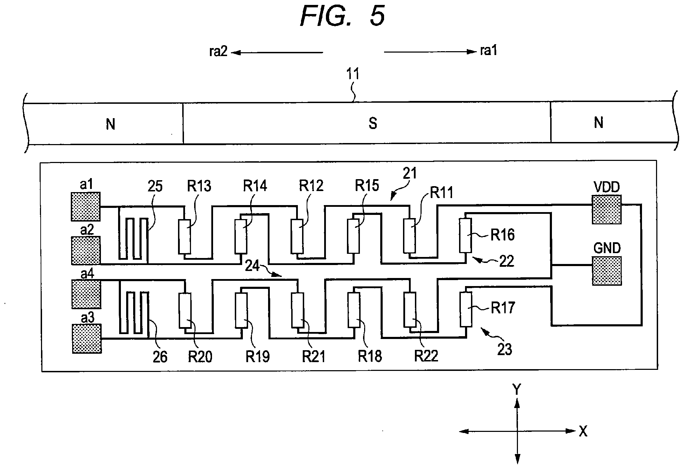

Fig. 1 is a plan view illustrating a magnetic encoder according to an embodiment. Fig. 2 is a cross-sectional view illustrating the magnetic encoder shown in Fig. 1. Fig. 3 (a) is a diagram illustrating the circuit structure of a magnetic detection device (magnetic sensor) according to a first embodiment. Fig. 3(b) is a diagram (schematic diagram) illustrating an output waveform at each position of an electric circuit shown in Fig. 3(a). Fig. 4 is a diagram (simulation diagram) illustrating output waveforms from a1, a4, a4-al, and al-a2 in the first embodiment. Fig. 5 is a schematic diagram illustrating the arrangement structure of the magnetic detection device according to the first embodiment and the relationship between the magnetic detection device and a magnet. As shown in Fig. 1, a magnet 11 has a ring shape in this embodiment. Fig. 5 shows the positional relationship between the magnet 11 and the magnetic detection element, in which the magnetized surface of the magnet 11 is expanded on the plane to form the magnetic sensor.

A magnetic encoder 10 according to this embodiment detects, for example, a rotation angle, a rotation direction, or a rotation speed. The magnetic encoder 10 includes the magnet (magnetic field generating member) 11, a rotating body 12 that rotatably supports the magnet 11, a housing 9 that rotatably supports the rotating body 12, and a magnetic detection device (magnetic sensor) 20 including a magnetic detection element and an integrated circuit.

For example, the magnet 11 has a ring shape and the outer circumferential surface of the rotating body 12 is fixed to the inner surface of the magnet 11. A plurality of magnetic poles including the N-poles and the S-poles are formed on the outer circumferential surface 11A of the magnet 11 at equal angular intervals.

The magnet 11 and the rotating body 12 are arranged in a circular concave portion 9A which is provided in the housing 9. As shown in Fig. 2, a through hole 9a is formed at the center of the housing 9. A rotating shaft 12a provided at the center of the rotating body 12 passes through the through hole 9a.

The magnet 11 is supported by the concave portion 9A so as to be rotatable about the rotating shaft 12a of the rotating body 12 in a counterclockwise direction ra1 and a clockwise direction ra2.

A portion of the concave portion 9A is cut out in the outer circumferential direction to form a cutout portion 9b in the housing 9. The magnetic detection device 20 is fixed inside the cutout portion 9b so as to face the outer circumferential surface 11A of the magnet 11.

As shown in Fig. 3(a) or Fig. 5, the magnetic detection device 20 is provided with a plurality of magnetic detection elements R11 to R22. Each of the magnetic detection elements is, for example, a GMR element (giant magnetoresistive effect element) and has a basic laminated structure of an antiferromagnetic layer, a finned magnetic layer, a non-magnetic layer, and a free magnetic layer. For example, the magnetization of the finned magnetic layer is fixed in a direction tangent to the rotation direction of the magnet 11. The pinned magnetic layers of all of the magnetic detection elements R11 to R22 are magnetized in the same direction.

As shown in Fig. 5, the magnetic detection elements R11 to R22 are arranged in a line in the direction (relative movement direction; X direction) tangent to the rotation direction of the magnet 11. As shown in Fig. 3(a) and Fig. 5, the magnetic detection elements R11, R12, and R13 are connected in series to each other between an input terminal Vdd, which is a terminal for applying a power supply voltage, and the first output portion al to form a first detecting unit 21. As shown in Fig. 3(a) and Fig. 5, the magnetic detection elements R14, R15, and R16 are connected in series to each other between a ground terminal GND and the second output portion a2 to form a second detecting unit 22. As shown in Fig. 5, the magnetic detection elements R11, R12, and R13 forming the first detecting unit 21 and the magnetic detection elements R14, R15, and R16 forming the second detecting unit 22 are alternately arranged in the relative movement direction (X direction) of the magnet 11.

As shown in Fig. 3(a) and Fig. 5, the magnetic detection elements R17, R18, and R19 are connected in series to each other between the input terminal Vdd and the third output portion a3 to form a third detecting unit 23. As shown in Fig. 3(a) and Fig. 5, the magnetic detection elements R20, R21, and R22 are connected in series to each other between the ground terminal GND and the fourth output portion a4 to form a fourth detecting unit 24. As shown in Fig. 5, the magnetic detection elements R17, R18, and R19 forming the third detecting unit 23 and the magnetic detection elements R20, R21, and R22 forming the fourth detecting unit 24 are alternately arranged in the relative movement direction (X direction).

As shown in Fig. 5, the magnetic detection elements R11 to R13 forming the first detecting unit 21 and the magnetic detection elements R20 to R22 forming the fourth detecting unit 24 are arranged so as to face each other in a direction (Y direction) orthogonal to the relative movement direction (the X direction in Fig. 5).

In addition, as shown in Fig. 5, the magnetic detection elements R14 to R16 forming the second detecting unit 22 and the magnetic detection elements R17 to R19 forming the third detecting unit 23 are arranged so as to face each other in a direction (Y direction) orthogonal to the relative movement direction (the X direction in Fig. 5).

As shown in Fig. 5, all of the magnetic detection elements R11 to R22 provided in the magnetic detection device 20 are arranged in the range of one of the N-poles (or the S-poles) of the magnet 11. In Fig. 5, in the detecting units 21 to 24, a plurality of magnetic detection elements forming each of the detecting units 21 to 24 are arranged at pitches of λ/3 (λ is a magnetic pole width) and the pitch between each of the magnetic detection elements forming the first detecting unit 21 (third detecting unit 23) and each of the magnetic detection elements forming the second detecting unit 22 (fourth detecting unit 24) is λ/6.

The magnetic detection elements R11 to R22 have the same layer structure and the same planar shape. In addition, the magnetic detection elements R11 to R22 have substantially the same resistance value. It is preferable that each of the magnetic detection elements R11 to R22 be formed in a meander shape in order to increase the resistance value.

In this way, a bridge circuit 27 including the plurality of magnetic detection elements R11 to R22 is formed. As shown in Fig. 3(a), the magnetic detection elements R11 to R16 forming the first detecting unit 21 and the second detecting unit 22 are connected in series to each other in a first series circuit 28 of the bridge circuit 27. Two output portions a1 and a2 are provided at an intermediate point where the magnetic detection elements R11 to R16 are divided into two groups including the same number of magnetic detection elements. In this embodiment, as shown in Fig. 3(a) and Fig. 5, a first resistive unit 25 is connected between the first output portion a1 and the second output portion a2. As shown in Fig. 3(a) , the magnetic detection elements R17 to R22 forming the third detecting unit 23 and the fourth detecting unit 24 are connected in series to each other in a second series circuit 29 of the bridge circuit 27. Two output portions a3 and a4 are provided at an intermediate point where the magnetic detection elements R17 to R22 are divided into two groups including the same number of magnetic detection elements. In this embodiment, as shown in Fig. 3(a) and Fig. 5, a second resistive unit 26 is connected between the third output portion a3 and the fourth output portion a4.

In this embodiment, the first resistive unit 25 and the second resistive unit 26 are fixed resistors (having a resistance value that is not changed by the external magnetic field from the magnet 11).

In this embodiment, as shown in Fig. 3(a), the first output portion a1 and the fourth output portion a4 are directly connected to a first comparator 30. In addition, as shown in Fig. 3(a), the second output portion a2 and the third output portion a3 are directly connected to a second comparator 31. Standard operational amplifiers may be used as the comparators 30 and 31.

As shown in Fig. 3(a), the output side of the first comparator 30 and the output side of the second comparator 31 are connected to an OR circuit 32.

It is assumed that, in an initial state, the magnetic field of the magnet 11 is applied to all of the magnetic detection elements R11 to R22 in the same direction (for example, in a direction opposite to the magnetization direction of the finned magnetic layer) and all of the magnetic detection elements R11 to R22 have the same resistance value (for example, all of the magnetic detection elements R11 to R22 have the maximum resistance value). In this state, when the magnet 11 is rotated, for example, in the direction ra1 of Fig. 5, the magnetic field applied to the magnetic detection element R13 and the magnetic detection element R20 is changed in the opposite direction (for example, in the same direction as the magnetization direction of the finned magnetic layer). Then, for example, when the resistance values of the magnetic detection element R13 and the magnetic detection element R20 are changed so as to be reduced with the change in the direction of the magnetic field, output voltages from the first output portion a1 and the second output portion a2 are changed from a reference voltage, which is a voltage in the initial state, by a value corresponding to a change in the resistance value of the magnetic detection element R13. In addition, output voltages from the third output portion a3 and the fourth output portion a4 are changed from the reference voltage by a value corresponding to a change in the resistance value of the magnetic detection element R20.

For example, when the magnet 11 is further rotated and the resistance values of the magnetic detection elements R13 and R20 and the magnetic detection elements R14 and R19 are changed so as to be reduced, the combined resistance value of the first detecting unit 21 is equal to the combined resistance value of the second detecting unit 22. Then, the output voltages from the first output portion a1 and the second output portion a2 are substantially equal to the reference voltage in the initial state . Similarly, since the combined resistance value of the third detecting unit 23 is equal to the combined resistance value of the fourth detecting unit 24, the output voltages from the third output portion a3 and the fourth output portion a4 are substantially equal to the reference voltage in the initial state.

Fig. 3(b) is a diagram schematically illustrating the waveforms of the output voltages from the output portions a1 to a4.

As shown in Fig. 3(b), the output voltage from the first output portion a1 includes high output regions VA1 in which a high output voltage higher than a reference voltage V1 is repeatedly output three times with the reference voltage V1 interposed therebetween and low output regions VB1 in which a low output voltage lower than the reference voltage V1 are repeatedly output three times with the reference voltage V1 interposed therebetween. The high output regions VA1 and the low output regions VB1 are alternately arranged. When the combined resistance value of the first detecting unit 21 is equal to the combined resistance value of the second detecting unit 22, the reference voltage V1 is the output voltage obtained from the first output portion a1. The same holds for the reference voltages V2 to V4, which will be described below. That is, when the combined resistance value of the first detecting unit 21 is equal to the combined resistance value of the second detecting unit 22, a reference voltage V2 is the output voltage from the second output portion a2. When the combined resistance value of the third detecting unit 23 is equal to the combined resistance value of the fourth detecting unit 24, the reference voltages V3 and V4 are the output voltages from the third output portion a3 and the fourth output portion a4, respectively.

As shown in Fig. 3(b), the output voltage from the fourth output portion a4 includes low output regions VB4 in which a low output voltage lower than the reference voltage V4 is repeatedly output three times with the reference voltage V4 interposed therebetween and high output regions VA4 in which a high output voltage higher than the reference voltage V4 is repeatedly output three times with the reference voltage V4 interposed therebetween. The low output regions VB4 and the high output regions VA4 are alternately arranged.

The reference voltage V1 of the first output portion a1 shown in Fig. 3(b) shifts to the side higher than Vin/2 and the reference voltage V4 of the fourth output portion a4 shifts to the side lower than Vin/2. Vin is a power supply voltage applied to the input terminal Vdd. Therefore, there is a potential difference between the reference voltage V1 of the first output portion a1 and the reference voltage V4 of the fourth output portion a4. The potential difference is R_{fix}·Vᵢₙ/ (6R_{gmr}+R_{fix}) (where R_{fix} is the resistance values of the resistive units 25 and 26, R_{gmr} is the resistance value of each of the magnetic detection elements R11 to R22, and Vᵢₙ is an input voltage (power supply voltage) .

When the output voltage from the fourth output portion a4 is higher than the output voltage from the first output portion a1, the first comparator 30 shown in Fig. 3(a) generates a pulse signal ("high"-level signal). When the output voltage from the fourth output portion a4 is lower than the output voltage from the first output portion a1, the first comparator 30 generates a "low"-level signal. Fig. 3(b) shows an output waveform diagram b of the first comparator 30.

As shown in Fig. 3(b), the output voltage from the third output portion a3 includes low output regions VB3 in which a low output voltage lower than the reference voltage V3 is repeatedly output three times with the reference voltage V3 interposed therebetween and high output regions VA3 in which a high output voltage higher than the reference voltage V3 is repeatedly output three times with the reference voltage V3 interposed therebetween. The low output regions VB3 and the high output regions VA3 are alternately arranged.

As shown in Fig. 3 (b), the output voltage from the second output portion a2 includes high output regions VA2 in which a high output voltage higher than the reference voltage V2 is repeatedly output three times with the reference voltage V2 interposed therebetween and low output regions VB2 in which a low output voltage lower than the reference voltage V2 is repeatedly output three times with the reference voltage V2 interposed therebetween. The high output regions VA2 and the low output regions VB2 are alternately arranged.

The reference voltage V3 of the third output portion a3 shown in Fig. 3(b) shifts to the side higher than Vin/2 and the reference voltage V2 of the second output portion a2 shifts to the side lower than Vin/2. Therefore, there is a potential difference between the reference voltage V2 of the second output portion a2 and the reference voltage V3 of the third output portion a3. The reference voltage V3 is substantially equal to the reference voltage V1 and the reference voltage V2 is substantially equal to the reference voltage V4.

When the output voltage from the second output portion a2 is higher than the output voltage from the third output portion a3, the second comparator 31 shown in Fig. 3(a) generates a pulse signal ("high"-level signal) . When the output voltage from the second output portion a2 is lower than the output voltage from the third output portion a3, the second comparator 31 generates a "low"-level signal. Fig. 3(b) shows an output waveform diagram c of the second comparator 31.

The OR circuit 32 shown in Fig. 3 (a) synthesizes the pulse signal (output waveform diagram b shown in Fig. 3(b)) generated by the first comparator 30 with the pulse signal (output waveform diagram c shown in Fig. 3(b)) generated by the second comparator 31 to generate pulse signals which are continuously arranged substantially at equal intervals, as shown in an output waveform diagram d in Fig. 3(b).

In this embodiment, the magnetic detection device 20 outputs a signal corresponding to three pulses while being relatively moved a distance corresponding to one pole of the magnet 11. Therefore, it is possible to form a high-resolution magnetic encoder. When the number of magnetic detection elements provided in the magnetic pole width of one N-pole or one S-pole increases, it is possible to further improve resolution.

As shown in Fig. 3(a), in this embodiment, the bridge circuit 27 includes the magnetic detection elements R11 to R22 forming the detecting units 21 to 24, the first resistive unit 25 provided at the intermediate position of the first series circuit 28, the first output portion a1 provided between the first resistive unit 25 and the first detecting unit 21, and the second output portion a2 provided between the first resistive unit 25 and the second detecting unit 22. In addition, the bridge circuit 27 includes the second resistive unit 26 provided at the intermediate position of the second series circuit 29, the third output portion a3 provided between the second resistive unit 26 and the third detecting unit 23, and the fourth output portion a4 provided between the second resistive unit 26 and the fourth detecting unit 24. Therefore, it is possible to shift the reference voltages V1 and V3 of the output voltages from the first output portion a1 and the third output portion a3 to be higher than the reference voltage in the structure according to the related art in which the first resistive unit 25 and the second resistive unit 26 are not provided. In addition, it is possible to shift the reference voltages V2 and V4 of the output voltages from the second output portion a2 and the fourth output portion a4 to be lower than the reference voltage in the structure according to the related art in which the first resistive unit 25 and the second resistive unit 26 are not provided. Therefore, the bridge circuit 27 can generate a potential difference between the reference voltages of the output voltages from the first output portion a1 and the fourth output portion a4 connected to the same comparator 30 in advance. Similarly, the bridge circuit 27 can generate a potential difference between the reference voltages of the output voltages from the second output portion a2 and the third output portion a3 connected to the same comparator 31 in advance. As a result, even when a differential amplifier is not used in the first stage of the signal processing circuit in order to obtain a single-ended signal, the comparators 30 and 31 can generate a pulse signal with high accuracy and it is possible to obtain high detection accuracy with a simple circuit structure, as compared to the related art.

As such, in this embodiment, the differential amplifier does not need to be connected to the first stage of the signal processing circuit. However, electric elements, such as passive elements, may be connected between the output portions a1 to a4 and the comparators 30 and 31. As shown in Fig. 3(a), in this embodiment, the output portions a1 to a4 may be directly connected to the comparators 30 and 31. In this case, it is possible to achieve a small and simple circuit structure.

In the embodiment shown in Fig. 3, a fixed resistor is used as the resistive unit for shifting the reference voltage of each of the output portions a1 to a4. Fig. 4 shows the simulation results of an output waveform diagram from the first output portion a1, an output waveform diagram from the fourth output portion a4, an output waveform diagram obtained by subtracting the output voltage of the first output portion a1 from the output voltage of the fourth output portion a4, an enlarged output waveform diagram of a4-a1, and an output waveform diagram of a threshold voltage. The average resistance value R_{gmr} ((Rmax+Rmin) /2) of the magnetic detection elements R11 to R22 is 750 Ω and the resistance value R_{fix} of the first resistive unit 25 and the second resistive unit 26 is 40 Ω. In addition, the input voltage (power supply voltage) Vin in each simulation is 3.3 V.

The threshold voltage shown in Fig. 4 is calculated by subtracting the output voltage of the second output portion a2 from the output voltage of the first output portion a1. In addition, the threshold voltage may be calculated by subtracting the output voltage of the fourth output portion a4 from the output voltage of the third output portion a3.

As shown in the third output waveform diagram from the upper side of Fig. 4, a combined reference voltage (V4-V1) obtained by subtracting the reference voltage V1 of the first output portion a1 from the reference voltage V4 of the fourth output portion a4 is not substantially constant, but varies.

This is because the threshold voltage which is defined as described above is not constant, but varies, as shown in Fig. 4. The reason why the threshold voltage varies is that the resistive units 25 and 26 are fixed resistors . That is, the reason is that, when each resistance value where the reference voltage is obtained is changed, the ratio of the resistance value between each of the output portions a1 to a4 and the input terminal Vdd and the resistance value between each of the output portions a1 to a4 and the ground terminal GND is not constant.

When the first comparator 30 increases the output voltage from the fourth output portion a4 to be higher than the output voltage from the first output portion a1 to generate a pulse signal, the variation in the threshold voltage may cause, for example, the deviation between the generation timings of the pulse signals, a change in the width of the pulse, or chattering. The same problem as described above also occurs in the pulse output from the second comparator 31. The structure in which the first comparator 30 and the second comparator 31 have hysteresis makes it possible to improve matters to a certain extent. By performing such an improvement so that the threshold voltage has a substantially constant value, it becomes possible to more effectively improve operation stability. Next, the structure in which the threshold voltage has a substantially constant value will be described.

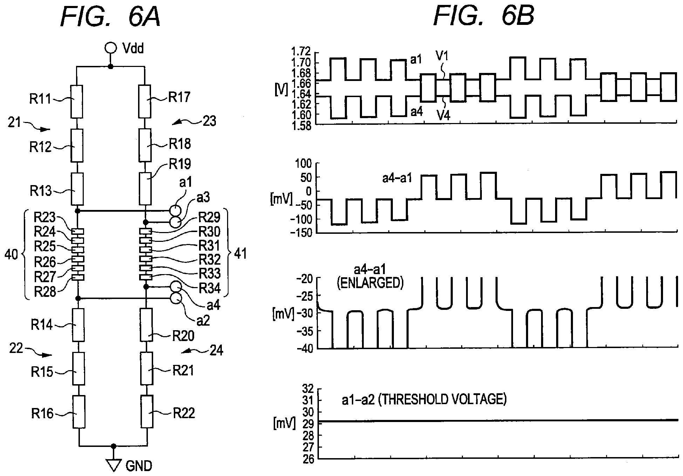

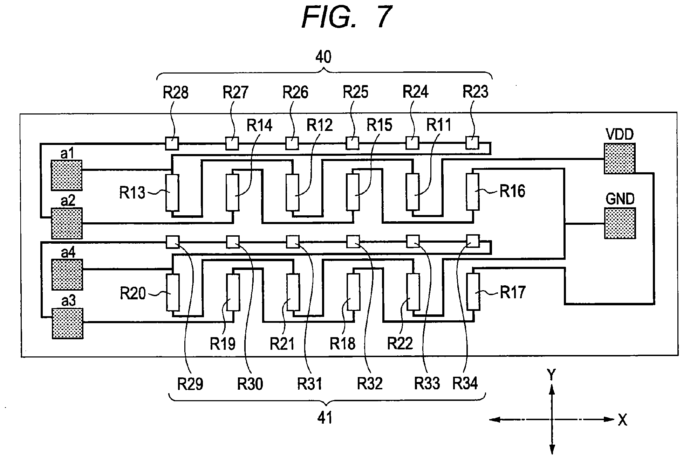

Fig. 6(a) is a bridge circuit diagram of a magnetic detection device according to a second embodiment. Fig. 6(b) is a diagram (simulation diagram) illustrating output waveforms from a1, a4, a4-a1, and a1-a2 in the second embodiment. Fig. 7 is a diagram illustrating the arrangement structure of the magnetic detection device according to the second embodiment. In each of the drawings, the same components as those in Figs. 3 and 5 are denoted by the same reference numerals. In Fig. 7, the magnet 11 is not shown. However, in the second embodiment, similarly to Fig. 5, the magnet 11 is arranged in the X direction of Fig. 7.

In the embodiment shown in Figs. 6 and 7, a first resistive unit 40 connected between a first detecting unit 21 and a second detecting unit 22 includes six magnetic detection elements R23 to R28 which are connected in series to each other. The number of magnetic detection elements R23 to R28 provided in the first resistive unit 40 is equal to the number of magnetic detection elements R11 to R16 forming the first detecting unit 21 and the second detecting unit 22. A second resistive unit 41 connected between a third detecting unit 23 and a fourth detecting unit 24 includes six magnetic detection elements R29 to R34 which are connected in series to each other. The number of magnetic detection elements R29 to R34 provided in the second resistive unit 41 is equal to the number of magnetic detection elements R17 to R22 forming the third detecting unit 23 and the fourth detecting unit 24.

As shown in Fig. 7, the magnetic detection elements R23 to R28 forming the first resistive unit 40 are arranged so as to face the magnetic detection elements R11 to R16 forming the first detecting unit 21 and the second detecting unit 22 in a direction (the Y direction in Fig. 7) orthogonal to a relative movement direction (the X direction in Fig. 7), respectively. As shown in Fig. 7, the magnetic detection elements R29 to R34 forming the second resistive unit 41 are arranged so as to face the magnetic detection elements R17 to R22 forming the third detecting unit 23 and the fourth detecting unit 24 in a direction (the Y direction in Fig. 7) orthogonal to the relative movement direction (the X direction in Fig. 7).

All of the magnetic detection elements R11 to R22 forming the detecting units 21 to 24 and the magnetic detection elements R23 to R34 forming the resistive units 40 and 41 are, for example, GMR elements. In all of the GMR elements, the magnetization direction of a finned magnetic layer is aligned with a direction tangent to the rotation direction of the magnet 11.

It is assumed that, in an initial state, the magnetic field of the magnet 11 is applied to all of the magnetic detection elements R11 to R34 in the same direction (for example, in a direction opposite to the magnetization direction of the finned magnetic layer), and all of the magnetic detection elements R11 to R22 forming the detecting units 21 to 24 and all of the magnetic detection elements R23 to R34 forming the resistive units 40 and 41 have the same resistance value (for example, all of the magnetic detection elements R11 to R34 have the maximum resistance value) . In this state, similarly to the first embodiment, at the same time as the same magnet 11 as that shown in Fig. 5 is rotated and the resistance values of the magnetic detection element R13 and the magnetic detection element R20 shown in Fig. 7 are changed (reduced), the resistance values of the magnetic detection elements R28 and R29 forming the resistive units 40 and 41 are also changed (reduced).

In addition, at the same time as the magnet 11 is further moved and the resistance values of the magnetic detection elements R14 and R19 and the magnetic detection elements R13 and R20 shown in Fig. 7 are changed, the resistance values of the magnetic detection elements R28, R29, R27, and R30 forming the resistive units 40 and 41 are also changed.

In the embodiment shown in Fig. 7, the resistance values of the magnetic detection elements R23 to R28 forming the first resistive unit 40 are changed corresponding to a change in the resistance values of the magnetic detection elements 11 to R16 forming the first detecting unit 21 and the second detecting unit 22. Similarly, the resistance values of the magnetic detection elements R29 to R34 forming the second resistive unit 41 are changed corresponding to a change in the resistance values of the magnetic detection elements 17 to R22 forming the third detecting unit 23 and the fourth detecting unit 24.

The waveform diagram shown in Fig. 6 (b) is the simulation result when the average resistance value R_{gmr} of the magnetic detection elements R11 to R22 is 750 Ω and the average resistance value R_{gmr} of the magnetic detection elements R23 to R34 forming the resistive units 40 and 41 is 6.7 Ω. The input voltage (power supply voltage) Vin is 3.3 V.

When the reference voltage of each of the output portions a1 to a4 is considered, the reference voltage is output from each of the output portions a1 to a4 in the initial state in which all of the magnetic detection elements in the detecting units 21 to 24 have the same resistance value and the state in which the magnetic detection device 20 is relatively moved in the relative movement direction and the resistance values of the magnetic detection elements which are arranged in the same place in the detecting units 21 to 24 are changed.

That is, when the magnetic detection device 20 is moved relative to the magnet 11 in the initial state and the resistance value of the magnetic detection element R13 in the first detecting unit 21, the resistance value of the magnetic detection element R14 in the second detecting unit 22, the resistance value of the magnetic detection element R19 in the third detecting unit 23, and the resistance value of the magnetic detection element R20 in the fourth detecting unit 24 shown in Fig. 7 are changed, the output voltage from each of the output portions a1 to a4 returns to the same reference voltage as that in the initial state. In this case, among the six magnetic detection elements R23 to 28 of the resistive unit 40 and the six magnetic detection elements R29 to R34 of the resistive unit 41, the resistance values of two magnetic detection elements R27 and R28 and two magnetic detection elements R29 and R30 are changed.

The output voltage from the first output portion a1 is considered. The output voltage is calculated by multiplying the ratio of the resistance value of the first detecting unit 21 to the resistance value of the first series circuit 28 by the input voltage Vᵢₙ, which is a power supply voltage. When a plurality of magnetic detection elements R23 to R28 are connected in series to each other to form the first resistive unit 40 as shown in Fig. 7, the ratio of the resistance value of the first detecting unit 21 to the combined resistance value of the first resistive unit 40 and the second detecting unit 22 at the reference voltage V1 is constant all the time. That is, for example, when the resistance value of the first detecting unit 21 is changed from Rx to k·Rx, the combined resistance value of the first resistive unit 40 and the second detecting unit 22 is also changed from Ry to k·Ry. Therefore, it is possible to make the reference voltage V1 of the first output portion a1 substantially constant. The same holds for the reference voltages V2 to V4 of the output voltages from the second output portion a2, the third output portion a3, and the fourth detecting portion.

Therefore, as shown in Fig. 6, it is possible to make the threshold voltage determined in this way substantially constant and thus adjust and generate the generation timing of the pulse signal or the width of the pulse signal with high accuracy. Therefore, it is possible to effectively improve operation stability.

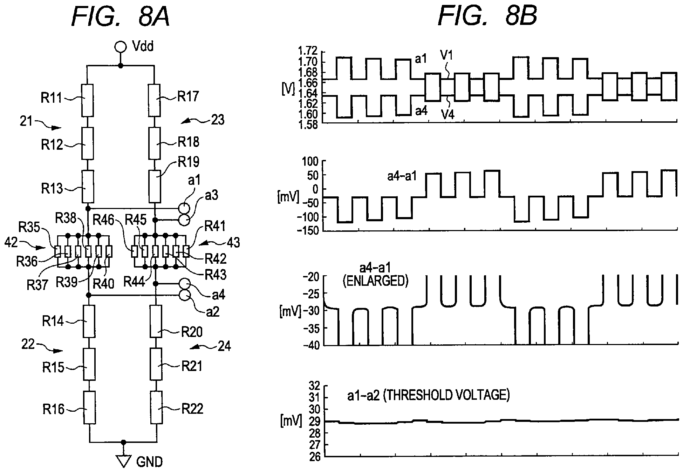

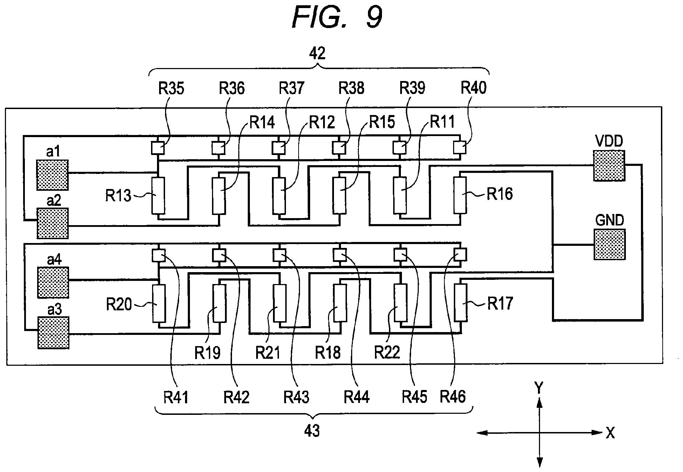

Fig. 8(a) is a bridge circuit diagram illustrating a magnetic detection device according to a third embodiment. Fig. 8(b) is a diagram (simulation diagram) illustrating output waveforms from a1, a4, a4-a1, and al-a2 in the third embodiment. Fig. 9 is a diagram illustrating the arrangement structure of the magnetic detection device according to the third embodiment. In each of the drawings, the same components as those in Figs. 3 and 5 are denoted by the same reference numerals. In Fig. 9, the magnet 11 is not shown. However, in the third embodiment, similarly to Fig. 5, the magnet 11 is arranged in the X direction of Fig. 9.

In the embodiment shown in Figs. 8 and 9, a first resistive unit 42 connected between a first detecting unit 21 and a second detecting unit 22 includes six magnetic detection elements R35 to R40 which are connected in parallel to each other. The number of magnetic detection elements R35 to R40 provided in the first resistive unit 42 is equal to the number of magnetic detection elements R11 to R16 forming the first detecting unit 21 and the second detecting unit 22. A second resistive unit 43 connected between a third detecting unit 23 and a fourth detecting unit 24 includes six magnetic detection elements R41 to R46 which are connected in parallel to each other. The number of magnetic detection elements R41 to R46 provided in the second resistive unit 43 is equal to the number of magnetic detection elements R17 to R22 forming the third detecting unit 23 and the fourth detecting unit 24.

As shown in Fig. 9, the magnetic detection elements R35 to R40 forming the first resistive unit 42 are arranged so as to face the magnetic detection elements R11 to R16 forming the first detecting unit 21 and the second detecting unit 22 in a direction (the Y direction in Fig. 9) orthogonal to the relative movement direction (the X direction in Fig. 9), respectively. As shown in Fig. 9, the magnetic detection elements R41 to R46 forming the second resistive unit 43 are arranged so as to face the magnetic detection elements R17 to R22 forming the third detecting unit 23 and fourth detecting unit 24 in a direction (the Y direction in Fig. 9) orthogonal to the relative movement direction (the X direction in Fig. 9), respectively.

All of the magnetic detection elements R11 to R22 forming the detecting unit 21 to 24 and the magnetic detection elements 35 to R46 forming the resistive units 42 and 43 are, for example, GMR elements. In all of the GMR elements, the magnetization direction of a finned magnetic layer is aligned with a direction tangent to the rotation direction of the magnet 11.

It is assumed that, similarly to the second embodiment, in an initial state, all of the magnetic detection elements R11 to R22 forming the detecting units 21 to 24 and all of the magnetic detection elements R35 to R46 forming the resistive units 42 and 43 have the same resistance value (for example, all of the magnetic detection elements R11 to R22 and R35 to R46 have the maximum resistance value). For example, at the same time as the same magnet 11 as that shown in Fig. 5 is rotated and the resistance values of the magnetic detection element R13 and the magnetic detection element R20 shown in Fig. 9 are changed (reduced), the resistance values of the magnetic detection elements R35 and R41 forming the resistive units 42 and 43 are also changed (reduced) .

At the same time as the magnet 11 is further rotated and the resistance values of the magnetic detection elements R13 and R20 and the magnetic detection element R14 and R19 shown in Fig. 9 are changed, the resistance values of the magnetic detection elements R35, R36, R41, and R42 forming the resistive units 42 and 43 are also changed.

In the embodiment shown in Fig. 9, the resistance values of the magnetic detection elements R35 to R40 forming the first resistive unit 42 are changed corresponding to a change in the resistance value of each of the magnetic detection elements R11 to R16 forming the first detecting unit 21 and the second detecting unit 22. Similarly, the resistance values of the magnetic detection elements R41 to R46 forming the second resistive unit 43 are changed corresponding to a change in the resistance value of each of the magnetic detection elements R17 to R22 forming the third detecting unit 23 and the fourth detecting unit 24.

The output waveform shown in Fig. 8 (b) is the simulation result when the average resistance value R_{gmr} of the magnetic detection elements R11 to R22 forming the detecting units 21 to 24 is 750 Ω and the average resistance value R_{gmr} of the magnetic detection elements R35 to R46 forming the resistive units 42 and 43 is 240 Ω. The input voltage (power supply voltage) Vin is 3.3 V.

As can be seen from Fig. 8 (b), there is a little deviation between the threshold voltage determined in the above-mentioned way and that in the structure according to the second embodiment shown in Fig. 6(b), that is, the structure in which a plurality of magnetic detection elements R23 to R34 are connected in series to each other to form the resistive units 40 and 41, but the threshold voltage can be sufficient improved, as compared to the structure shown in Fig. 4 in which the fixed resistor is used. Therefore, even in the structure in which the plurality of magnetic detection elements R35 to R46 are connected in parallel to each other to form the resistive units 42 and 43, it is possible to improve detection accuracy and operation stability.

The structure in which the plurality of magnetic detection elements R35 to R46 are connected in parallel to each other to form the resistive units 42 and 43 can increase the resistance value required for each magnetic detection element, as compared to the structure in which the plurality of magnetic detection elements R23 to R34 are connected in series to each other to form the resistive units 40 and 41.

For example, in the simulation shown in Fig. 4, the resistance value R_{fix} of each of the resistive units 25 and 26, which are the fixed resistors shown in Fig. 3(a), is set to 40 Ω. In the second embodiment shown in Fig. 6 in which a plurality of magnetic detection elements are connected in series to each other to form the resistive units 40 and 41, in order to set the same resistance value, it is necessary to adjust the resistance value (for example, the maximum resistance value) R_{gmr} of each of the magnetic detection elements R23 to R34 to about 6.7 Ω. As such, when a plurality of magnetic detection elements are connected in series to each other to form the resistive units 40 and 41, the set value of the resistance value R_{gmr} of each magnetic detection element is reduced. Therefore, for example, when wiring resistance is considered, the aspect conditions of each of the magnetic detection elements R23 to R34 require very high accuracy, which makes it difficult to adjust the resistance value R_{gmr} .

In contrast, in the embodiment shown in Fig. 8 in which a plurality of magnetic detection elements are connected in parallel to each other to form the resistive units 42 and 43, it is possible to set the resistance value (for example, average resistance value) R_{gmr} of each of the magnetic detection elements R35 to R46 to about 240 Ω. As such, since it is possible to increase the set value of the resistance value R_{gmr} required for each of the magnetic detection elements R35 to R46, it is possible to simplify the structure of the magnetic detection elements R35 to R46.

In the embodiment shown in Figs. 6 and 8, similarly to the detecting units 21 to 24, each of the resistive units 40 to 43 includes magnetic detection elements. Therefore, it is possible to reduce a variation in the relative resistance value or temperature characteristics of each magnetic detection element.

The magnetic detection elements R11 to R22 forming the detecting units 21 to 24 may be, for example, AMR elements. When each of the resistive units 40 to 43 includes a plurality of magnetic detection elements, the magnetic detection elements of each of the resistive units 40 to 43 may be, for example, AMR elements. When a GMR element or a TMR element having a high rate of change of resistance is used, it is possible to increase an output voltage and improve the accuracy of detection.

In the above-described embodiments, the rotary encoder in which the magnet 11 is rotated is used. However, for example, an encoder in which the magnet 11 has a rod shape and is linearly moved may be used. In addition, a structure in which the magnet is fixed and the magnetic sensor is moved may be used.

In the above-described embodiments, the magnetic detection device 20 is used in the magnetic encoder 10. However, the detection device 20 may be applied to apparatuses other than the magnetic encoder.

### REFERENCE SIGNS LIST

R11 TO R46: MAGNETIC DETECTION ELEMENT
V1 TO V4: REFERENCE VOLTAGE
a1 TO a4: OUTPUT PORTION
10: MAGNETIC ENCODER
11: MAGNET
12: ROTATING BODY
20: MAGNETIC DETECTION DEVICE (MAGNETIC SENSOR)
21 TO 24: DETECTING UNIT
25, 26, 40, 41, 42, 43: RESISTIVE UNIT
27: BRIDGE CIRCUIT
28, 29: SERIES CIRCUIT
30, 31: COMPARATOR

## Claims

1. A magnetic detection device (20) comprising a bridge circuit (27), the bridge circuit (27) comprising:
a first series circuit (28) comprising a first detecting unit (21), a first resistive unit (25), and a second detecting unit (22) which are connected in series, the first detecting unit (21) and the second detecting unit (22) comprising a plurality of magnetic detection elements (R11, R12, R13, R14, R15, R16) which are connected in series, respectively, wherein a terminal of the first detecting unit (21) is connected to an input terminal (Vdd) to which a power supply voltage is applied and a terminal of the second detecting unit (22) is connected to a ground terminal (GND); and
a second series circuit (29) comprising a third detecting unit (23), a second resistive unit (26), and a fourth detecting unit (24) which are connected in series, the third detecting unit (23) and the fourth detecting unit (24) comprising a plurality of magnetic detection elements (R17, R18, R19, R20, R21, R22) which are connected in series, respectively, wherein a terminal of the third detecting unit (23) is connected to the input terminal (Vdd) and a terminal of the fourth detecting unit (24) is connected to the ground terminal (GND),
wherein a first output portion (a1) is provided at an intermediate point between the first detecting unit (21) and the first resistive unit (25), and a second output portion (a2) is provided at an intermediate point between the first resistive unit (25) and the second detecting unit (22),
wherein a third output portion (a3) is provided at an intermediate point between the third detecting unit (23) and the second resistive unit (26), and a fourth output portion (a4) is provided at an intermediate portion between the second resistive unit (26) and the fourth detecting unit (24), and
wherein the first output portion (a1) and the fourth output portion (a4) are connected to a first comparator(30), and the second output portion (a2) and the third output portion (a3) are connected to a second comparator (31).

2. The magnetic detection device according to claim 1, wherein the fourth detecting unit (24) has a resistance value which is changed together with a resistance value of the first detecting unit (21), and wherein the third detecting unit (23) has a resistance value which is changed together with a resistance value of the second detecting unit (22).

3. The magnetic detection device (20) according to claim 2,
wherein each of the first resistive unit (40) and the second resistive unit (41) includes a plurality of magnetic detection elements (R23-R34) connected in series to each other,
the magnetic detection elements (R23-R28) forming the first resistive unit (40) are arranged such that the resistance values thereof are changed corresponding to the resistance values of the magnetic detection elements (R11-R16) forming the first detecting unit (21) and the second detecting unit (22), and
the magnetic detection elements (R29-R34) forming the second resistive unit (41) are arranged such that the resistance values thereof are changed corresponding to the resistance values of the magnetic detection elements (R17-R22) forming the third detecting unit (23) and the fourth detecting unit (24).

4. The magnetic detection device (20) according to claim 2,
wherein each of the first resistive unit (42) and the second resistive unit (43) includes a plurality of magnetic detection elements (R35-R46) connected in parallel to each other,
the magnetic detection elements (R35-R40) forming the first resistive unit (42) are arranged such that the resistance values thereof are changed corresponding to the resistance values of the magnetic detection elements (R11-R16) forming the first detecting unit (21) and the second detecting unit (22), and
the magnetic detection elements (R41-R46) forming the second resistive unit (43) are arranged such that the resistance values thereof are changed corresponding to the resistance values of the magnetic detection elements (R17-R22) forming the third detecting unit (23) and the fourth detecting unit (24).

5. The magnetic detection device (20) according to claim 2 or 3,
wherein the magnetic detection elements (R11-R16) forming the first detecting unit (21) and the second detecting unit (22) are arranged so as to face a magnetized surface, which generates the external magnetic field in which the N-poles and the S-poles are alternately arranged in a relative movement direction, with a gap therebetween in the relative movement direction,
wherein the magnetic detection elements (R17-R19) forming the third detecting unit (23) are arranged so as to face the magnetic detection elements (R14-R16) forming the second detecting unit (22) with a gap therebetween in a direction orthogonal to the relative movement direction,
wherein the magnetic detection elements (R20-R22) forming the fourth detecting unit (24) are arranged so as to face the magnetic detection elements (R11-R13) forming the first detecting unit (21) with a gap therebetween in the direction orthogonal to the relative movement direction,
wherein the magnetic detection elements (R11-R13) forming the first resistive unit (21) are arranged so as to face the magnetic detection elements (R11-R16) forming the first detecting unit (21) and the second detecting unit (22) with a gap therebetween in the direction orthogonal to the relative movement direction, and
wherein the magnetic detection elements (R14-R16) forming the second resistive unit (22) are arranged so as to face the magnetic detection elements (R17-R22) forming the third detecting unit (23) and the fourth detecting unit (24) with a gap therebetween in the direction orthogonal to the relative movement direction.

6. The magnetic detection device (20) according to claim 5,
wherein the first detecting unit (21), the second detecting unit (22), the third detecting unit (23), and the fourth detecting unit (24) include the same number of magnetic detection elements (R11-R22),
wherein the magnetic detection elements (R11-R13) forming the first detecting unit (21) and the magnetic detection elements (R14-R16) forming the second detecting unit (22) are alternately arranged in the relative movement direction so as to be within a magnetic pole width, and
the magnetic detection elements (R17-R19) forming the third detecting unit (23) and the magnetic detection elements (R20-R22) forming the fourth detecting unit (24) are alternately arranged in the relative movement direction so as to be within the magnetic pole width.

7. The magnetic detection device (20) according to claim 2,
wherein the first resistive unit (25) and the second resistive unit (26) are fixed resistors.

8. The magnetic detection device according to any one of claims 1 to 7,
wherein each output portion (a1-a4) and each comparator (30, 31) are directly connected to each other.

## Patentansprüche

1. Magnetische Detektionsvorrichtung (20) mit einer Brückenschaltung (27), wobei die Brückenschaltung (27) aufweist:
eine erste Reihenschaltung (28) mit einer ersten Detektionseinheit (21), einer ersten Widerstandseinheit (25) und einer zweiten Detektionseinheit (22), die miteinander in Reihe geschaltet sind, wobei die erste Detektionseinheit (21) und die zweite Detektionseinheit (22) eine Mehrzahl von jeweils in Reihe geschalteten magnetischen Detektionselementen (R11, R12, R13, R14, R15, R16) aufweist, wobei ein Anschluss der ersten Detektionseinheit (21) mit einem Eingangsanschluss (Vdd) verbunden ist, an den eine Stromversorgungsspannung angelegt wird, und ein Anschluss der zweiten Detektionseinheit (22) mit einem Masseanschluss (GND) verbunden ist; und
eine zweite Reihenschaltung (29) mit einer dritten Detektionseinheit (23), einer zweiten Widerstandseinheit (26) und einer vierten Detektionseinheit (24), die miteinander in Reihe geschaltet sind, wobei die dritte Detektionseinheit (23) und die vierte Detektionseinheit (24) eine Mehrzahl von jeweils in Reihe geschalteten magnetischen Detektionselementen (R17, R18, R19, R20, R21, R22) aufweist, wobei ein Anschluss der dritten Detektionseinheit (23) mit dem Eingangsanschluss (Vdd) verbunden ist und ein Anschluss der vierten Detektionseinheit (24) mit dem Masseanschluss (GND) verbunden ist,
wobei ein erster Ausgangsbereich (a1) an einer zwischengeordneten Stelle zwischen der ersten Detektionseinheit (21) und der ersten Widerstandseinheit (25) vorgesehen ist und ein zweiter Ausgangsbereich (a2) an einer zwischengeordneten Stelle zwischen der ersten Widerstandseinheit (25) und der zweiten Detektionseinheit (22) vorgesehen ist,
wobei ein dritter Ausgangsbereich (a3) an einer zwischengeordneten Stelle zwischen der dritten Detektionseinheit (23) und der zweiten Widerstandseinheit (26) vorgesehen ist und ein vierter Ausgangsbereich (a4) an einer zwischengeordneten Stelle zwischen der zweiten Widerstandseinheit (26) und der vierten Detektionseinheit (24) vorgesehen ist, und
wobei der erste Ausgangsbereich (a1) und der vierte Ausgangsbereich (a4) mit einem ersten Komparator (30) verbunden sind und der zweite Ausgangsbereich (a2) und der dritte Ausgangsbereich (a3) mit einem zweiten Komparator (31) verbunden sind.

2. Magnetische Detektionsvorrichtung nach Anspruch 1,
wobei die vierte Detektionseinheit (24) einen Widerstandswert aufweist, der sich zusammen mit einem Widerstandswert der ersten Detektionseinheit (21) ändert, und wobei die dritte Detektionseinheit (23) einen Widerstandswert aufweist, der sich zusammen mit einem Widerstandswert der zweiten Detektionseinheit (22) ändert.

3. Magnetische Detektionsvorrichtung (20) nach Anspruch 2,
wobei die erste Widerstandseinheit (40) und die zweite Widerstandseinheit (41) jeweils eine Mehrzahl von magnetischen Detektionselementen (R23-R34) aufweisen, die miteinander in Reihe geschaltet sind,
wobei die die erste Widerstandseinheit (40) bildenden magnetischen Detektionselemente (R23-R28) derart angeordnet sind, dass sich die Widerstandswerte derselben entsprechend den Widerstandswerten der magnetischen Detektionselemente (R11-R16) ändern, die die erste Detektionseinheit (21) und die zweite Detektionseinheit (22) bilden, und
wobei die die zweite Widerstandseinheit (41) bildenden magnetischen Detektionselemente (R29-R34) derart angeordnet sind, dass sich die Widerstandswerte derselben entsprechend den Widerstandswerten der magnetischen Detektionselemente (R17-R22) ändern, die die dritte Detektionseinheit (23) und die vierte Detektionseinheit (24) bilden.

4. Magnetische Detektionsvorrichtung (20) nach Anspruch 2,
wobei die erste Widerstandseinheit (42) und die zweite Widerstandseinheit (43) jeweils eine Mehrzahl von magnetischen Detektionselementen (R35-R36) aufweisen, die parallel miteinander verbunden sind,
wobei die die erste Widerstandseinheit (42) bildenden magnetischen Detektionselemente (R35-R40) derart angeordnet sind, dass sich die Widerstandswerte derselben in Abhängigkeit von den Widerstandswerten der magnetischen Detektionselemente (R11-R16) ändern, die die erste Detektionseinheit (21) und die zweite Detektionseinheit (22) bilden, und
wobei die die zweite Widerstandseinheit (43) bildenden magnetischen Detektionselemente (R41-R46) derart angeordnet sind, dass sich die Widerstandswerte derselben in Abhängigkeit von den Widerstandswerten der magnetischen Detektionselemente (R17-R22) ändern, die die dritte Detektionseinheit (23) und die vierte Detektionseinheit (24) bilden.

5. Magnetische Detektionsvorrichtung (20) nach Anspruch 2 oder 3,
wobei die die erste Detektionseinheit (21) und die zweite Detektionseinheit (22) bildenden magnetischen Detektionselemente (R11-R16) derart angeordnet sind, dass sie einer magnetisierten Fläche zugewandt gegenüberliegen, die ein externes Magnetfeld erzeugt, in dem die N-Pole und S-Pole abwechselnd in einer Relativbewegungsrichtung angeordnet sind, wobei ein Spalt dazwischen in der Relativbewegungsrichtung vorhanden ist,
wobei die die dritte Detektionseinheit (23) bildenden magnetischen Detektionselemente (R17-R19) derart angeordnet sind, dass sie den die zweite Detektionseinheit (22) bildenden magnetischen Detektionselementen (R14-R16) mit einem Spalt dazwischen in einer Richtung orthogonal zu der Relativbewegungsrichtung zugewandt gegenüberliegen,
wobei die die vierte Detektionseinheit (24) bildenden magnetischen Detektionselemente (R20-R22) derart angeordnet sind, dass sie den die erste magnetische Detektionseinheit (21) bildenden magnetischen Detektionselementen (R11-R13) mit einem Spalt dazwischen in der Richtung orthogonal zu der Relativbewegungsrichtung zugewandt gegenüberliegen,
wobei die die erste Widerstandseinheit (21) bildenden magnetischen Detektionselemente (R11-R13) derart angeordnet sind, dass sie den die erste Detektionseinheit (21) und die zweite Detektionseinheit (22) bildenden magnetischen Detektionselementen (R11-R16) mit einem Spalt dazwischen in der Richtung orthogonal zu der Relativbewegungsrichtung zugewandt gegenüberliegen, und
wobei die die zweite Widerstandseinheit (22) bildenden magnetischen Detektionselemente (R14-R16) derart angeordnet sind, dass sie den die dritte Detektionseinheit (23) und die vierte Detektionseinheit (24) bildenden magnetischen Detektionselementen (R17-R22) mit einem Spalt dazwischen in der Richtung orthogonal zu der relativen Bewegungsrichtung zugewandt gegenüberliegen.

6. Magnetische Detektionsvorrichtung (20) nach Anspruch 5,
wobei die erste Detektionseinheit (21), die zweite Detektionseinheit (22), die dritte Detektionseinheit (23) und die vierte Detektionseinheit (24) die gleiche Anzahl von magnetischen Detektionselementen (R11-R22) aufweisen,
wobei die die erste Detektionseinheit (21) bildenden magnetischen Detektionselemente (R11-R13) und die die zweite Detektionseinheit (22) bildenden magnetischen Detektionselemente (R14-R16) in der Relativbewegungsrichtung abwechselnd derart angeordnet sind, dass sie sich innerhalb einer Magnetpolbreite befinden, und
wobei die die dritte Detektionseinheit (23) bildenden magnetischen Detektionselemente (R17-R19) und die die vierte Detektionseinheit (24) bildenden magnetischen Detektionselemente (R20-R22) in der Relativbewegungsrichtung abwechselnd derart angeordnet sind, dass sie sich innerhalb der Magnetpolbreite befinden.

7. Magnetische Detektionsvorrichtung (20) nach Anspruch 2,
wobei es sich bei der ersten Widerstandseinheit (25) und der zweiten Widerstandseinheit (26) um feste Widerstände handelt.

8. Magnetische Detektionsvorrichtung nach einem der Ansprüche 1 bis 7,
wobei jeder Ausgangsbereich (a1-a4) und jeder Komparator (30, 31) direkt miteinander verbunden sind.

## Revendications

1. Dispositif de détection magnétique (20) comprenant un circuit en pont (27), le circuit en pont (27) comprenant :
un premier circuit en série (28) comprenant une première unité de détection (21), une première unité faisant office de résistance (25) et une deuxième unité de détection (22), qui sont montées en série, la première unité de détection (21) et la deuxième unité de détection (22) comprenant plusieurs éléments de détection magnétique (R11, R12, R13, R14, R15, R16) qui sont montés en série, respectivement, dans lequel une borne de la première unité de détection (21) est reliée à une borne d'entrée (Vdd) à laquelle s'applique une tension de source d'alimentation et une borne de la deuxième unité de détection (22) est reliée à une borne de mise à la terre (GND) ; et
un deuxième circuit en série (29) comprenant une troisième unité de détection (23), une deuxième unité faisant office de résistance (26) et une quatrième unité de détection (24), qui sont montées en série, la troisième unité de détection (23) et la quatrième unité de détection (24) comprenant plusieurs éléments de détection magnétique (R17, R18, R19, R20, R21, R22) qui sont montés en série, respectivement, dans lequel une borne de la troisième unité de détection (21) est reliée à la borne d'entrée (Vdd) et une borne de la quatrième unité de détection (24) est reliée à une borne de mise à la terre (GND) ;
dans lequel une première portion de sortie (a1) est disposée à un endroit intermédiaire situé entre la première unité de détection (21) et la première unité faisant office de résistance (25), et une deuxième portion de sortie (a2) est disposée à un endroit intermédiaire situé entre la première unité faisant office de résistance (25) et la deuxième unité de détection (22) ;
dans lequel une troisième portion de sortie (a3) est disposée à un endroit intermédiaire situé entre la troisième unité de détection (23) et la deuxième unité faisant office de résistance (26), et une quatrième portion de sortie (a4) est disposée à un endroit intermédiaire situé entre la deuxième unité faisant office de résistance (26) et la quatrième unité de détection (24) ; et
dans lequel la première portion de sortie (a1) et la quatrième portion de sortie (a4) sont reliées à un premier comparateur (30), et la deuxième portion de sortie (a2) et la troisième portion de sortie (a3) sont reliées à un deuxième comparateur (31).

2. Dispositif de détection magnétique selon la revendication 1, dans lequel la quatrième unité de détection (24) possède une valeur de résistance qui est modifiée conjointement avec une valeur de résistance de la première unité de détection (21) et dans lequel le la troisième unité de détection (23) possède une valeur de résistance qui est modifiée conjointement avec une valeur de résistance de la deuxième unité de détection (22).

3. Dispositif de détection magnétique (20) selon la revendication 2,
dans lequel chaque unité parmi la première unité faisant office de résistance (40) et la deuxième unité faisant office de résistance (41) englobe plusieurs éléments de détection magnétique (R23-R34) reliés les uns aux autres en étant montés en série ;
les éléments de détection magnétique (R23-R28) formant la première unité faisant office de résistance (40) sont conçus d'une manière telle que leurs valeurs de résistance sont modifiées de manière correspondante aux valeurs de résistance des éléments de détection magnétique (R11-R16) formant la première unité de détection (21) et la deuxième unité de détection (22) ; et
les éléments de détection magnétique (R29-R34) formant la deuxième unité faisant office de résistance (41) sont conçus d'une manière telle que leurs valeurs de résistance sont modifiées de manière correspondante aux valeurs de résistance des éléments de détection magnétique (R17-R22) formant la troisième unité de détection (23) et la quatrième unité de détection (24).

4. Dispositif de détection magnétique (20) selon la revendication 2,
dans lequel chaque unité parmi la première unité faisant office de résistance (42) et la deuxième unité faisant office de résistance (43) englobe plusieurs éléments de détection magnétique (R35-R46) reliés les uns aux autres en étant montés en parallèle ;
les éléments de détection magnétique (R35-R40) formant la première unité faisant office de résistance (42) sont conçus d'une manière telle que leurs valeurs de résistance sont modifiées de manière correspondante aux valeurs de résistance des éléments de détection magnétique (R11-R16) formant la première unité de détection (21) et la deuxième unité de détection (22) ; et
les éléments de détection magnétique (R41-R46) formant la deuxième unité faisant office de résistance (43) sont conçus d'une manière telle que leurs valeurs de résistance sont modifiées de manière correspondante aux valeurs de résistance des éléments de détection magnétique (R17-R22) formant la troisième unité de détection (23) et la quatrième unité de détection (24).

5. Dispositif de détection magnétique (20) selon la revendication 2 ou 3,
dans lequel les éléments de détection magnétique (R11-R16) formant la première unité de détection (21) et la deuxième unité de détection (22) sont conçus pour faire face à une surface magnétisée qui génère le champ magnétique externe dans lequel les pôles n et les pôles s sont disposés en alternance dans une direction de mouvement relatif, avec un espace libre intermédiaire dans la direction de mouvement relatif ;
dans lequel les éléments de détection magnétique (R17-R19) formant la troisième unité de détection (23) sont conçus pour faire face aux éléments de détection magnétique (R14-R16) formant la deuxième unité de détection (22), avec un espace libre intermédiaire dans une direction perpendiculaire à la direction de mouvement relatif ;
dans lequel les éléments de détection magnétique (R20-R22) formant la quatrième unité de détection (24) sont conçus pour faire face aux éléments de détection magnétique (R11-R13) formant la première unité de détection (21), avec un espace libre intermédiaire dans la direction perpendiculaire à la direction de mouvement relatif ;
dans lequel les éléments de détection magnétique (R11-R13) formant la première unité faisant office de résistance (21) sont conçus pour faire face aux éléments de détection magnétique (R11-R16) formant la première unité de détection (21) et la deuxième unité de détection (22), avec un espace libre intermédiaire dans la direction perpendiculaire à la direction de mouvement relatif ;
dans lequel les éléments de détection magnétique (R14-R16) formant la deuxième unité faisant office de résistance (22) sont conçus pour faire face aux éléments de détection magnétique (R17-R22) formant la troisième unité de détection (23) et la quatrième unité de détection (24), avec un espace libre intermédiaire dans la direction perpendiculaire à la direction de mouvement relatif.

6. Dispositif de détection magnétique (20) selon la revendication 5,
dans lequel la première unité de détection (21), la deuxième unité de détection (22), la troisième unité de détection (23) et la quatrième unité de détection (24) englobent le même nombre d'éléments de détection magnétique (R11-R22) ;
dans lequel les éléments de détection magnétique (R11-R13) formant la première unité de détection (21) et les éléments de détection magnétique (R14-R16) formant la deuxième unité de détection (22) sont disposés en alternance dans la direction de mouvement relatif de façon à se retrouver au sein d'une largeur de pôle magnétique ; et
dans lequel les éléments de détection magnétique (R17-R19) formant la troisième unité de détection (23) et les éléments de détection magnétique (R20-R22) formant la quatrième unité de détection (24) sont disposés en alternance dans la direction de mouvement relatif de façon à se retrouver au sein d'une largeur de pôle magnétique.

7. Dispositif de détection magnétique (20) selon la revendication 2,
dans lequel la première unité faisant office de résistance (25) et la deuxième unité faisant office de résistance (26) représentent des résistances fixes.

8. Dispositif de détection magnétique (20) selon l'une quelconque des revendications 1 à 7,
dans lequel chaque portion de sortie (a1-a4) et chaque comparateur (30, 31) sont reliés l'un à l'autre de manière directe.
